# EUROPEAN PATENT SPECIFICATION

(11) **EP 3 329 520 B1**
(45) Date of publication and mention of the grant of the patent: **13.01.2021**
(21) Application number: 16733586.8
(22) Date of filing: 30.06.2016
(51) Int. Cl.: H01L 31/062, H01L 31/07

(54) **BACK CONTACT PHOTOVOLTAIC CELLS WITH INDUCED JUNCTIONS**
FOTOVOLTAIKZELLEN MIT RÜCKKONTAKT MIT INDUZIERTEN ÜBERGÄNGEN
CELLULES PHOTOVOLTAÏQUES À CONTACT ARRIÈRE À JONCTIONS INDUITES

(30) Priority: 28.07.2015 EP 15178675
(43) Date of publication of application: 06.06.2018
(73) Proprietor: IMEC vzw, 3001 Leuven (BE); Kuwait University, 13060 Safat (KW)
(72) Inventor: POORTMANS, Jef, 3001 Leuven (BE); GHANNAM, Mustafa, 3001 Leuven (BE); ABDULRAHEEM, Yaser, 3001 Leuven (BE)
(74) Representative: AWA Sweden AB
(86) International application number: PCT/EP2016/065372
(87) International publication number: WO 2017/016789

(56) References cited:
- JP-A- S5 679 477
- US-A- 4 315 097
- US-A1- 2010 084 009
- US-A1- 2011 284 064
- US-A1- 2012 285 517
- US-A1- 2012 285 518
- US-A1- 2014 224 306
- US-B1- 8 486 747
- G. SONG: "Diffusion-free back-contact cells on S-passivated p-type Si(100) substrates", PROCEEDINGS OF THE 33RD IEEE PHOTOVOLTAIC SPECIALIST CONFERENCE, 2008, XP002761019, cited in the application

## Description

### Field

The present disclosure is related to photovoltaic cells and to methods for fabricating photovoltaic cells. More in particular, the present disclosure is related to back contact silicon photovoltaic cells and to methods for fabricating back contact silicon photovoltaic cells.

### State of the art

Methods are known for fabricating back contact photovoltaic cells, such as interdigitated back contact (IBC) photovoltaic cells, for example crystalline silicon back contact cells, see for example US 2014/0224306 A1. Such cells typically have a pattern of p-doped regions and n-doped regions and corresponding p-type contacts and n-type contacts at the rear side of the cell.

Known fabrication processes for IBC cells are rather complex and costly. For example, when the IBC cell structure is based on an interdigitated pattern of homo-junction emitter regions and back surface field regions at the rear side, care has to be taken to separate these differently doped regions from each other, to avoid shunting of the cells. Additionally, the dopant diffusion steps used to realize the high doping levels require a high thermal budget which is putting at risk the high bulk minority carrier lifetimes required to have optimal performance for a back-contacted photovoltaic cell.

In a fabrication process for heterojunction IBC cells, an interdigitated pattern of differently doped amorphous silicon layers is deposited on the rear side of a crystalline silicon substrate. The amorphous silicon layers forming the heterojunctions at the rear side typically consist of a stack of several layers, for example comprising a few nm thin intrinsic amorphous silicon layer for interface passivation and on top of it either a highly p-type doped amorphous Si layer (e.g. for forming the emitter regions) or a highly doped n-type amorphous Si layer (e.g. for forming heterojunction contacts to the base). The need for providing such a stack of layers results in a rather complex fabrication process. On top of these amorphous silicon layers a transparent conductor layer and a metal contact layer are typically deposited. The transparent conductor layer separates the amorphous silicon layer from the metal contacts, thereby reducing optical losses and enhancing the back surface reflection.

In "Diffusion-free back-contact cells on S-passivated p-type Si(100) substrates", Proceedings of the 33rd IEEE Photovoltaic Specialist Conference, 2008, G. Song et al describe back contact photovoltaic cells based on a p-type crystalline silicon substrate with a field-induced p-n junction. The p-n junction is formed by a high Schottky barrier between low work-function aluminum and a sulfur-passivated p-type Si(100) surface. The sulfur passivation is performed in an aqueous solution of (NH₄)₂S. The high Schottky barrier induces degenerate inversion on the surface of the p-type silicon, leading to the formation of a p-n junction without the need for a dopant diffusion step. The photovoltaic cell conversion efficiency is low (about 1%), which is attributed to two key factors: surface passivation quality and minority carrier lifetime.

US 2012/285517 A1 discloses a Schottky Barrier solar cell having at least one of a low work function and a high work function region provided on the front or back surface of a lightly-doped absorber material.

### Summary

The present disclosure aims to provide back contact photovoltaic cells, such as interdigitated back contact photovoltaic cells, with good conversion efficiency, and methods for fabricating such back contact cells. Using a fabrication method in accordance with the present disclosure, the number of process steps is reduced as compared to known fabrication methods, resulting in a reduced complexity of the fabrication process as compared to known methods. The invention is defined by the appended claims.

According to the present disclosure there is provided a method for fabricating back contact photovoltaic cells, such as interdigitated back contact photovoltaic cells, wherein the fabrication can be done at low temperatures, such as for example at temperatures not exceeding 600°C.

According to the present disclosure there is provided a back contact photovoltaic cell, such as an interdigitated back contact photovoltaic cell, that can be fabricated using a low temperature fabrication process, e.g. a fabrication process that is performed at temperatures not exceeding 600°C, with a reduced number of process steps as compared to known fabrication methods, wherein the photovoltaic cell has a good energy conversion efficiency and wherein the photovoltaic cell can have an open-circuit voltage above 700 mV.

The present disclosure provides a back contact photovoltaic cell comprising a silicon substrate and comprising at a back side or rear side of the silicon substrate an emitter region at first predetermined locations and a back surface field region at second predetermined locations, the second predetermined locations being different from and non-overlapping with the first predetermined locations, wherein the emitter region and the back surface field region are field induced regions.

According to the present disclosure, the back contact photovoltaic cell may comprise a first layer stack on the rear surface of the silicon substrate at the first predetermined locations. The back contact photovoltaic cell may further comprise a second layer stack on the rear surface of the silicon substrate at the second predetermined locations. The first layer stack, e.g. a material or a combination of materials of the first layer stack, may be selected to induce an inversion region in the silicon substrate at the first predetermined locations, the inversion region forming (e.g. corresponding to) the emitter region. The second layer stack, e.g. a material or a combination of materials of the second layer stack, may be selected to induce an accumulation region in the silicon substrate at the second predetermined locations, the accumulation region forming (e.g. corresponding to) the back surface field region.

According to the present disclosure, the silicon substrate may for example be an n-type silicon substrate. The back contact photovoltaic cell may comprise a first layer stack on the rear surface of the silicon substrate at the first predetermined locations, the first layer stack comprising a passivating tunneling layer and a first transparent conductive layer comprising a material with a high work function. The high work function material of the first transparent conductive layer may be selected to induce the emitter region at the first predetermined locations. The high work function material of the first transparent conductive layer may for example have a work function in the range between 5 eV and 6 eV, the present disclosure not being limited thereto. The back contact photovoltaic cell may further comprise a second layer stack on the rear surface of the silicon substrate at the second predetermined locations, the second layer stack comprising a passivating tunneling layer and a second transparent conductive layer comprising a material with a low work function. The low work function material of the second transparent conductive layer may be selected to induce a back surface field region at the second predetermined locations. The low work function material of the second transparent conductive layer may for example have a work function in the range between 3.5 eV and 4.5 eV, the present disclosure not being limited thereto.

In a photovoltaic cell according to the present disclosure, the emitter region (inversion region) is induced as a result of the presence of the passivating tunneling layer and the first transparent conductive layer at the first predetermined locations. The back surface field region (accumulation region) is induced as a result of the presence of the passivating tunneling layer and the second transparent conductive layer at the second predetermined locations.

The passivating tunneling layer may for example be a thin dielectric layer, such as for example a thin silicon oxide layer or a thin intrinsic amorphous silicon layer, or a monolayer of a passivating atomic species, such as for example a S or Se monolayer or a Cl monolayer, the present disclosure not being limited thereto. The thickness of the dielectric layer may for example be in the range between 1 nm and 5 nm, for example between 1 nm and 3 nm, for example between 1 nm and 2 nm, the present disclosure not being limited thereto.

The first layer stack may further comprise a first metal layer or first metal stack on the first transparent conductive layer and the second layer stack may further comprise a second metal layer or second metal stack on the second transparent conductive layer.

The first transparent conductive layer and/or the second transparent conductive layer may comprise a stack of at least two layers, e.g. a stack of two layers.

In the present disclosure, the first predetermined locations may be interdigitated with the second predetermined locations.

The disclosure further provides a method for fabricating a back contact photovoltaic cell. The method comprises providing at first predetermined locations on a rear surface of a silicon substrate a first layer stack wherein the first layer stack induces an inversion region (emitter region) in the silicon substrate at the first predetermined locations; and providing at second predetermined locations on the rear surface of the silicon substrate a second layer stack wherein the second layer stack induces an accumulation region (back surface field region) in the silicon substrate at the second predetermined locations, the second predetermined locations being different from and non-overlapping with the first predetermined locations.

According to the present disclosure, the silicon substrate may for example be an n-type silicon substrate. A method according to the present disclosure may comprise providing at the first predetermined locations on the rear surface of the silicon substrate a first layer stack, wherein providing the first layer stack comprises providing a passivating tunneling layer on the rear surface of the silicon substrate and providing a first transparent conductive layer comprising a material with a high work function, e.g. a work function in the range between 5 eV and 6 eV, on the passivating tunneling layer at the first predetermined locations, The method may further comprise providing at the second predetermined locations on the rear surface of the silicon substrate a second layer stack, wherein providing the second layer stack comprises providing a passivating tunneling layer on the rear surface of the silicon substrate and providing a transparent conductive layer comprising a material with a low work function, e.g. a work function in the range between 3.5 eV and 4.5 eV, on the passivating tunneling layer at the second predetermined locations, the second predetermined locations being different from and non-overlapping with the first predetermined locations.

A fabrication method according to the present disclosure may be performed at temperatures not exceeding 600°C.

In a method of the present disclosure, providing the passivating tunneling layer may comprise providing a thin dielectric layer, such as for example a thin silicon oxide layer or a thin intrinsic amorphous silicon layer. Known methods may be used for providing the thin dielectric layer.

In a method of the present disclosure, providing the passivating tunneling layer may comprise providing a monolayer of a passivating atomic species, such as for example a S, Se or Cl monolayer. Such monolayer may for example be provided by wet chemical processing, or preferably by means of a Chemical Vapor Deposition method.

In the present disclosure, the first transparent conductive layer and/or the second transparent conductive layer may be provided by solution processing.

The method may further comprise providing a first metal layer or a first metal stack on the first transparent conductive layer and providing a second metal layer or a second metal stack on the second transparent conductive layer.

In the present disclosure, the first predetermined locations may be interdigitated with the second predetermined locations.

It is an advantage of a method of the present disclosure that it can be performed at a lower cost as compared to known fabrication methods for back contact cells photovoltaic cells, e.g. interdigitated back contact photovoltaic cells. The lower cost is related to a reduced number of process steps and/or a reduced thermal budget as compared to known methods for fabricating back contact photovoltaic cells, e.g. interdigitated back contact photovoltaic cells.

It is an advantage of a method of the present disclosure that it enables low temperature fabrication of interdigitated back contact photovoltaic cells, i.e. fabrication at temperatures not exceeding 600°C. It is an advantage of a low temperature fabrication process that it allows maintaining a high bulk minority carrier lifetime.

It is an advantage of a method of the present disclosure and of a photovoltaic device of the present disclosure that the induced emitter region (inversion layer) does not suffer from physical degradation associated with heavy doping, such as for example mobility degradation and/or bandgap narrowing effects. When using an induced emitter, the desired carrier concentrations may be achieved without the risk of doping related degradation.

Certain objects and advantages of various inventive aspects have been described herein above. Of course, it is to be understood that not necessarily all such objects or advantages may be achieved in accordance with any particular embodiment of the disclosure. Thus, for example, those skilled in the art will recognize that the disclosure may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the disclosure. The disclosure, both as to organization and method of operation, together with features and advantages thereof, may best be understood by reference to the following detailed description when read in conjunction with the accompanying drawings.

### Brief description of the figures

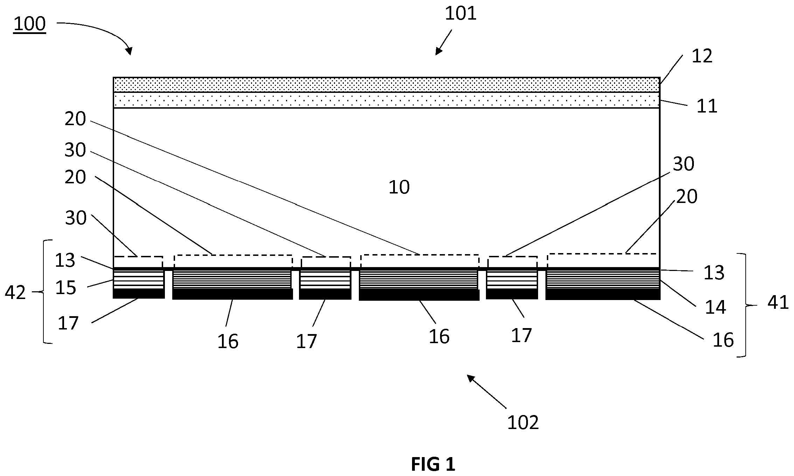

FIG 1 schematically shows a cross section of a back contact photovoltaic cell in accordance with an embodiment of the present disclosure.

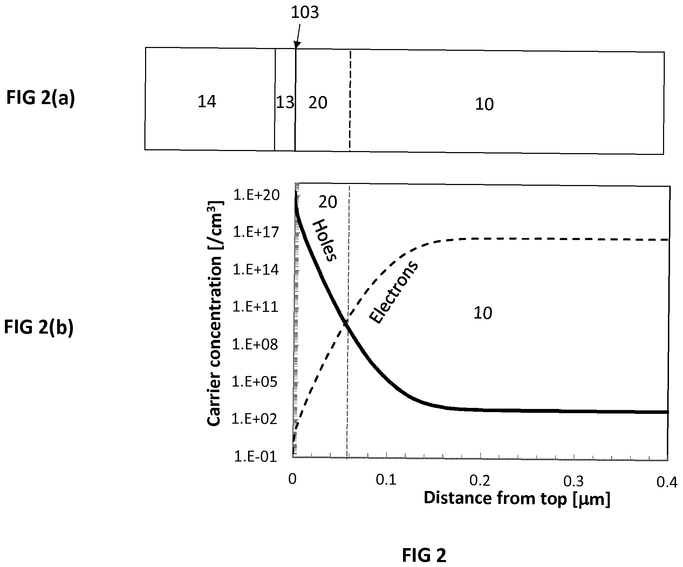

FIG 2(a) schematically shows a cross section of a structure comprising an n-type silicon substrate having a surface coated with a stack of a 2 nm thin SiO₂ layer and a transparent conductive oxide with a work function of 6 eV. FIG 2(b) shows calculated hole and electron concentrations for the structure of FIG 2(a), illustrating the formation of a p-type inversion layer in a surface region of the substrate, in accordance with an embodiment of the present disclosure.

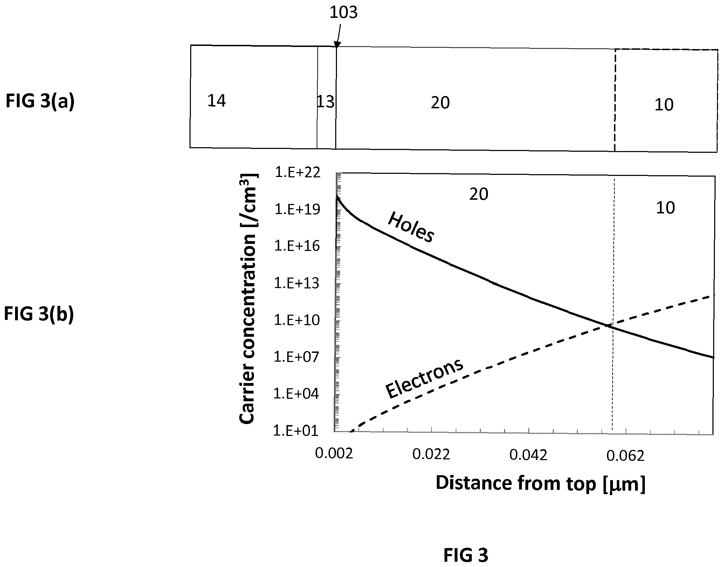

FIG 3(a) schematically shows a cross section of a structure comprising an n-type substrate coated with a stack of a 2 nm thin intrinsic amorphous silicon layer and a transparent conductive oxide with a work function of 6 eV. FIG 3(b) shows calculated hole and electron concentrations for the structure of FIG 3(a), illustrating the formation of a p-type inversion layer in a surface region of the substrate, in accordance with an embodiment of the present disclosure.

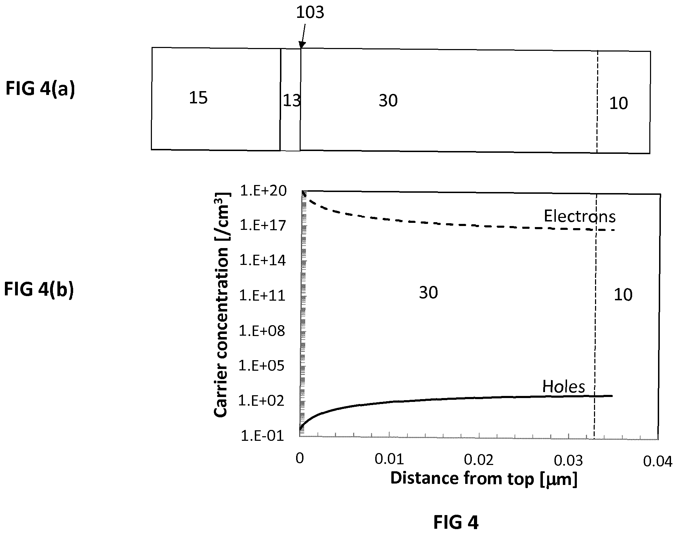

FIG 4(a) schematically shows a cross section of a structure comprising an n-type substrate coated with a stack of a 2 nm thin SiO₂ layer and a transparent conductive oxide with a work function of 3.5 eV. FIG 4(b) shows calculated hole and electron concentrations for the structure of FIG 4(a), illustrating the formation of an n-type (n⁺) accumulation layer in a surface region of the substrate, in accordance with an embodiment of the present disclosure.

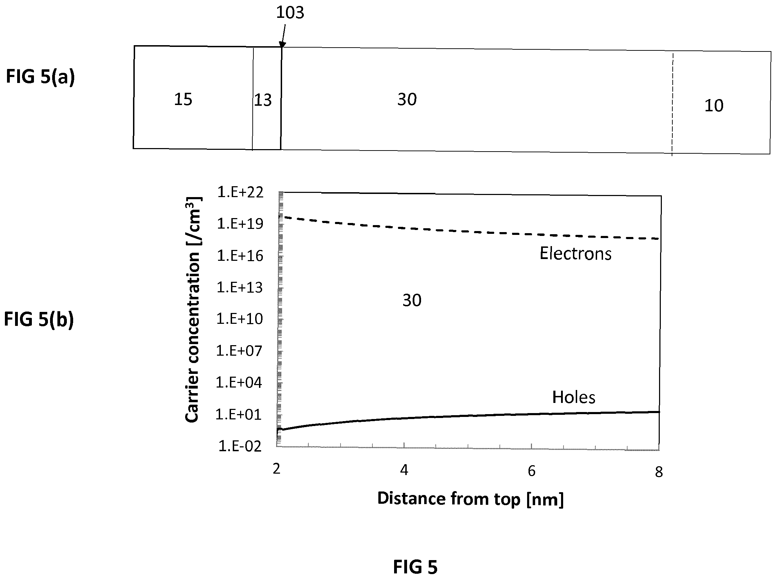

FIG 5(a) schematically shows a cross section of a structure comprising an n-type substrate coated with a stack of a 2 nm thin intrinsic amorphous silicon layer and a transparent conductive oxide with a work function of 3.5 eV. FIG 5(b) shows calculated hole and electron concentrations for the structure of FIG 5(a), illustrating the formation of an n-type (n⁺) accumulation layer in a surface region of the substrate, in accordance with an embodiment of the present disclosure.

Any reference signs in the claims shall not be construed as limiting the scope of the present disclosure.

In the different drawings, the same reference signs refer to the same or analogous elements.

### Detailed description

In the following detailed description, numerous specific details are set forth in order to provide a thorough understanding of the disclosure and how it may be practiced in particular embodiments. However, it will be understood that the present disclosure may be practiced without these specific details. In other instances, well-known methods, procedures and techniques have not been described in detail, so as not to obscure the present disclosure.

The present disclosure will be described with respect to particular embodiments and with reference to certain drawings but the disclosure is not limited thereto but only by the claims. The drawings described are only schematic and are nonlimiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising components A and B" should not be limited to devices consisting only of components A and B.

In the context of the present disclosure, the front surface or front side of a photovoltaic cell is the surface or side adapted for being oriented towards a light source and thus for receiving illumination. The back surface, rear surface, back side or rear side of a photovoltaic cell is the surface or side opposite to the front surface or side. The front side of a substrate used to form a photovoltaic cell is the side of the substrate corresponding to the front side of the photovoltaic cell, while the rear side or back side of the substrate corresponds to the back side of the photovoltaic cell.

In the context of the present disclosure, a tunnelling layer is a thin layer, for example a 1 nm to 3 nm thin layer, for example made of an electrically insulating material, wherein charge carriers, e.g. electrons, can pass through the layer by quantum tunnelling. In the context of the present disclosure, a passivating tunnelling layer is a tunnelling layer that has a surface passivating effect, i.e. a layer that reduces the surface state density of the underlying surface, e.g. silicon surface, and as a result reduces the surface recombination velocity.

An example of a back contact photovoltaic cell 100 according to an embodiment of the present disclosure is schematically shown in FIG 1 (cross section). The photovoltaic cell 100 comprises a crystalline silicon substrate 10 (base 10), which can for example be an n-type substrate. However, the present disclosure is not limited thereto and the substrate 10 may be a p-type substrate. In the further description an n-type substrate 10 is assumed. The substrate 10 preferably has a high minority carrier lifetime and typically has a resistivity in the range between 1 ohm-cm and 10 ohm-cm. The front surface or front side 101 of the photovoltaic cell 100 may be textured (not shown in FIG 1). The photovoltaic cell 100 may for example have a Front Surface Field region 11 and an antireflection coating 12 at the front side 101. The Front Surface Field region may for example be formed by diffusion of n-type dopants into the substrate 10. Alternatively, the Front Surface Field region may be field induced or it may be charge induced, e.g. by providing on the front surface a layer having a high positive charge density, such as for example a silicon nitride layer with a positive fixed charge density.

At the rear side 102 of the cell 100, preferably on the entire rear surface of the cell 100, a passivating tunneling layer 13 is present. The passivating tunneling layer 13 can for example be a thin dielectric layer such as for example a 1 nm to 3 nm thin silicon oxide layer, intrinsic amorphous silicon layer or AlOₓ layer, the present disclosure not being limited thereto. The passivating tunneling layer 13 may for example be a thin layer, e.g. a monolayer, of a passivating atomic species. For example, S or Se can be used as a passivating atomic species on an (100) oriented silicon surface. For example, Cl can be used as a passivating atomic species on an (111) oriented silicon surface. The presence of the passivating tunneling layer 13 on the crystalline silicon substrate rear surface results in a reduction of the surface state density, making the crystalline silicon surface sensitive to the work function of a material provided on the passivating tunneling layer.

The photovoltaic cell 100 further comprises a first transparent conductive layer 14 on top of the passivating tunneling layer 13 at first predetermined locations, the first transparent conductive layer 14 comprising a material with a high work function. The high work function material of the first transparent conductive layer 14 is selected with a suitably high work function to invert a surface region of the n-type silicon substrate 10 and to thereby induce a p⁺ Si /n Si junction between the inverted surface region and the bulk 10 at the first predetermined locations. In the photovoltaic cell 100 the inverted surface region forms an emitter region 20. A photovoltaic cell 100 of the present disclosure thus comprises an induced emitter region 20, more in particular a field induced emitter region 20. In a photovoltaic cell 100 of the present disclosure the emitter region 20 is thus not formed by diffusion of dopants into the substrate but it is formed by creating (inducing) an inversion layer in a surface region of the silicon substrate. The high work function material of the first transparent conductive layer 14 preferably has a work function in the range between 5 eV and 6 eV. Examples of high work function materials that may be used are Mo₂O₃ and NiO, the present disclosure not being limited thereto.

FIG 2 and FIG 3 illustrate the formation of a field induced p⁺ Si/n Si junction (e.g. corresponding to an emitter region 20 in a photovoltaic cell according to the present disclosure) in a surface region of an n-type silicon substrate 10, the induced junction resulting from the presence of a stack comprising a thin passivating tunneling layer 13 and a first transparent conductive layer 14 comprising a material with a high work function on the substrate surface.

FIG 2(a) schematically shows a cross section of a structure comprising an n-type silicon substrate 10 having a surface 103 coated with a stack of a 2 nm thin SiO₂ layer (passivating tunneling layer 13) and a transparent conductive oxide 14 with a work function of 6 eV. The structure shown in FIG 2(a) is used for simulating (calculating) the effect of providing such a stack on a silicon substrate, as used in a method and device of the present disclosure for inducing an emitter region 20. FIG 2(b) shows calculated hole and electron concentrations for the structure of FIG 2(a), illustrating the formation of a p-type inversion layer (emitter region 20) in a surface region of the substrate 10.

FIG 3(a) schematically shows a cross section of a structure comprising an n-type substrate 10 coated with a stack of a 2 nm thin intrinsic amorphous silicon layer (passivating tunneling layer 13) and a transparent conductive oxide 14 with a work function of 6 eV. The structure shown in FIG 3(a) is used for simulating (calculating) the effect of providing such a stack on a silicon substrate, as used in a method and device of the present disclosure for inducing an emitter region 20. FIG 3(b) shows calculated hole and electron concentrations for the structure of FIG 3(a), illustrating the formation of a p-type inversion layer (emitter region 20) in a surface region of the substrate 10.

The photovoltaic cell 100 further comprises a second transparent conductive layer 15 on top of the passivating tunneling layer 13 at second predetermined locations, corresponding to locations where an electrical contact to the base or bulk 10 is formed (FIG 1). The second transparent conductive layer 15 comprises a material with a low work function. The low work function material of the second transparent conductive layer 15 is selected with a suitably low work function to induce an n⁺ region (accumulation region) and thus a high/low n+/n junction at the second predetermined locations. In the photovoltaic cell 100 the n⁺ region forms a Back Surface Field (BSF) region 30 at the second predetermined locations. A photovoltaic cell 100 of the present disclosure thus comprises an induced Back Surface Field region 30, more in particular a field induced Back Surface Field region 30. In a photovoltaic cell 100 of the present disclosure the Back Surface Field region 30 is thus not formed by diffusion of dopants into the substrate but it is formed by creating (inducing) an accumulation layer in a surface region of the silicon substrate. The low work function material of the second transparent conductive layer 15 preferably has a work function in the range between 3.5 eV and 4.5 eV. Examples of low work functions materials that may be used are ITO and Al doped ZnO, the present disclosure not being limited thereto.

FIG 4 and FIG 5 illustrate the formation of a field induced n⁺ accumulation region (e.g. corresponding to a back surface field region 30 in a photovoltaic cell according to the present disclosure) in a surface region of an n-type silicon substrate 10, the induced n⁺ region resulting from the presence of a stack comprising a thin passivating tunneling layer 13 and a second transparent conductive layer 15 comprising a material with a low work function on the substrate surface.

FIG 4(a) schematically shows a cross section of a structure comprising an n-type substrate 10 having a surface 103 coated with a stack of a 2 nm thin SiO₂ layer (passivating tunneling layer 13) and a transparent conductive oxide 15 with a work function of 3.5 eV. The structure shown in FIG 4(a) is used for simulating (calculating) the effect of providing such a stack on a silicon substrate, as used in a method and device of the present disclosure for inducing a back surface field region 30. FIG 4(b) shows calculated hole and electron concentrations for the structure of FIG 4(a), illustrating the formation of an n-type (n⁺) accumulation layer 30 in a surface region of the substrate.

FIG 5(a) schematically shows a cross section of a structure comprising an n-type substrate 10 coated with a stack of a 2 nm thin intrinsic amorphous silicon layer (passivating tunneling layer 13) and a transparent conductive oxide 15 with a work function of 3.5 eV. The structure shown in FIG 5(a) is used for simulating (calculating) the effect of providing such a stack on a silicon substrate, as used in a method and device of the present disclosure for inducing a back surface field region 30. FIG 5(b) shows calculated hole and electron concentrations for the structure of FIG 5(a), illustrating the formation of an n-type (n⁺) accumulation layer 30 in a surface region of the substrate 10.

In embodiments of the present disclosure, the first transparent conductive layer 14 and/or the second transparent conductive layer 15 may comprise a stack of two or more transparent conductive layers. For example, the first transparent conductive layer 14 may comprise a stack of a layer made of a material with a high work function and a layer made of a material with a good electrical conductivity. For example, the second transparent conductive layer 15 may comprise a stack of a layer made of a material having a low work function and a layer having a good electrical conductivity, to limit resistive losses.

The thickness of the first transparent conductive layer 14 and the thickness of the second transparent conductive layer 15 may for example be in the range between 50 nm and 200 nm, the present disclosure not being limited thereto.

The first transparent conductive layer 14 and the second transparent conductive layer 15 may function as an optical reflector, when combined with a metal layer (16, 17 in FIG 1) deposited on top of the transparent conductive layers 14, 15. The materials of the transparent conductive layers are preferably transparent in a range of wavelengths that can be absorbed by the silicon substrate material. Additionally, they are preferably transparent in the infrared wavelength range, which may lead to a reduced warming up of the photovoltaic cells in operation.

As illustrated in FIG 1, the photovoltaic cell 100 may further comprise a first metal layer 16 on top of the first transparent conductive layer 14 and a second metal layer 17 on top of the second transparent conductive layer 15. The first metal layer 16 and the second metal layer 17 may for example comprise a stack of metal layers, such as for example a Ti/Al/Cu stack, the present disclosure not being limited thereto.

It is an advantage that the metal layers 16, 17 may have a higher electrical conductivity than the underlying transparent conductor layers 14, 15, thus forming a low-resistance current path to an external load. The metal layers may further provide a good back surface optical reflectance of the cell.

The back contact photovoltaic cell 100 shown in the example of FIG 1 thus comprises at the first predetermined locations a first layer stack 41 on the substrate, the first layer stack 41 comprising a passivating tunneling layer 13, a first transparent conductive layer 14 comprising a material with a high work function and a first metal layer 16. The back contact photovoltaic cell 100 shown in the example of FIG 1 further comprises at the second predetermined locations a second layer stack 42 on the substrate, the second layer stack 42 comprising a passivating tunneling layer 13, a second transparent conductive layer 15 comprising a material with a low work function and a second metal layer 17.

In a method for fabricating a photovoltaic cell 100 according to an embodiment of the present disclosure as shown in the example of FIG 1, a passivating tunneling layer 13 is provided at the rear side 102, i.e. on the rear surface, of a crystalline silicon substrate 10. The passivating tunneling layer 13 may be provided on the entire rear surface of the silicon substrate, the present disclosure not being limited thereto. The passivating tunneling layer 13 may for example be a thin dielectric layer such as for example a thin silicon oxide layer or a thin intrinsic amorphous silicon layer. The passivating tunneling layer 13 may for example be a monolayer of a passivating atomic species, such as S or Se on (100) oriented silicon surfaces or Cl on (111) oriented silicon surfaces.

In a method of the present disclosure, two different transparent conductive layers or layer stacks are provided on the passivated rear surface of the silicon substrate 10, i.e. on the passivating tunneling layer 13. A first transparent conductive layer 14 comprising a high work function material is provided on top of the passivating tunneling layer 13 at first predetermined locations. The material of the first transparent conductive layer 14 is selected with a suitably high work function to induce an emitter region 20 (inversion region) in the silicon substrate at the first predetermined locations. A second transparent conductive layer 15 comprising a low work function material is provided on top of the passivating tunneling layer 13 at second predetermined locations, corresponding to locations where an electrical contact to the base 10 is to be formed. The material of the second transparent conductive layer 15 may be selected with a suitably low work function to induce a back surface field region (accumulation region) in the silicon substrate at the second predetermined locations. The first predetermined locations and the second predetermined locations are non-overlapping and preferably interdigitated. The first transparent conductive layer 14 and the second transparent conductive layer 15 may be (laterally) separated from each other by an electrically insulating medium such as an air gap (as illustrated in FIG 1) or a dielectric spacer (not illustrated).

In a method of fabricating a photovoltaic device according to an embodiment of the present disclosure, the first transparent conductive layer 14 and the second transparent conductive layer 15 may for example be provided by sputtering followed by patterning. In preferred embodiments the first transparent conductive layer 14 and the second transparent conductive layer 15 are provided using a direct patterning method. For example, in preferred embodiments the transparent conductive layers 14, 15 may be applied by a solution processing method, such as for example inkjet printing or slot die coating. However, the present disclosure is not limited thereto, and other solution based processing methods may be used. For example, self-assembled monolayers may be provided at the first and second predetermined locations, the self-assembled monolayers being matched to the solvents used in the precursors (e.g. inks) used for forming the first and second transparent conductive layers 14, 15. After depositing the transparent conductive layers by solution processing a heating step is performed, at a temperature that is dependent on the type of solution used for each of the transparent conductive layers.

Next a first metal layer 16 or a first stack of metal layers 16 is deposited on top of the first transparent conductive layer 14 and a second metal layer 17 or a second stack of metal layers 17 is deposited on top of the second transparent conductive layer 15. After deposition of the first metal layer 16 and after deposition of the second metal layer 17 a patterning step may be done to define and separate (electrically isolate) the different contact regions.

It is an advantage of a fabrication method according to embodiments of the present disclosure that there is no need for performing a dopant diffusion step. A fabrication method of the present disclosure does not require high temperature steps, i.e. steps at temperatures exceeding 600°C. It is an advantage of such low-temperature fabrication process that it may for example be compatible with processing, e.g. rear side processing, on a glass carrier or a glass superstrate. It is an advantage of such low-temperature fabrication process that it allows maintaining a high bulk minority carrier lifetime in the substrate.

The foregoing description details certain embodiments of the disclosure. It will be appreciated, however, that no matter how detailed the foregoing appears in text, the disclosure may be practiced in many ways. It should be noted that the use of particular terminology when describing certain features or aspects of the disclosure should not be taken to imply that the terminology is being re-defined herein to be restricted to including any specific characteristics of the features or aspects of the disclosure with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the invention.

## Claims

1. A back contact photovoltaic cell (100), comprising:
an n-type silicon substrate (10);
an emitter region (20) arranged at first predetermined locations at a rear side (102) of the n-type silicon substrate (10);
a back surface field region (30) arranged at second predetermined locations at the rear side (102) of the n-type silicon substrate (10), the second predetermined locations being different from and non-overlapping with the first predetermined locations, wherein the emitter region (20) and the back surface field region (30) are field induced regions;
a first layer stack (41) configured to induce an inversion region in the n-type silicon substrate at the first predetermined locations, the inversion region forming the emitter region (20); and
a second layer stack (42) configured to induce an accumulation region in the n-type silicon substrate at the second predetermined locations, the accumulation region forming the back surface field region (30);
wherein:
each of the first layer stack (41) and the second layer stack (42) comprises a passivating tunneling layer structure (13) arranged on the n-type silicon substrate (10);
the first layer stack (41) further comprises a first transparent conductive layer (14) arranged on the passivating tunneling layer structure (13) and comprising a material with a high work function for inducing the emitter region (20); and
the second layer stack (42) further comprises a second transparent conductive layer (15) arranged on the passivating tunneling layer structure (13) and comprising a material with a low work function for inducing the back surface field region (30).

2. The back contact photovoltaic cell (100) according to claim 1, wherein the first transparent conductive layer (14) comprises a material with a work function in the range between 5 eV and 6 eV.

3. The back contact photovoltaic cell (100) according to claim 1 or 2, wherein the second transparent conductive layer (15) comprises a material with a work function in the range between 3.5 eV and 4.5 eV.

4. The back contact photovoltaic cell (100) according to any of the preceding claims, wherein the passivating tunneling layer (13) is a thin dielectric layer or a monolayer of a passivating atomic species.

5. The back contact photovoltaic cell (100) according to any of the preceding claims, wherein the first layer stack (41) further comprises a first metal layer (16) on the first transparent conductive layer (14) and wherein the second layer stack (42) further comprises a second metal layer (17) on the second transparent conductive layer (15).

6. A method for fabricating a back contact photovoltaic cell (100), the method comprising:
providing at first predetermined locations on a rear surface of an n-type silicon substrate (10) a first layer stack (41), wherein the first layer stack (41) is configured to induce an emitter region (20) in the n-type silicon substrate (10) at the first predetermined locations; and
providing at second predetermined locations on the rear surface of the n-type silicon substrate (20) a second layer stack (42), wherein the second layer stack (42) is configured to induce a back surface field region (30) in the n-type silicon substrate (10) at the second predetermined locations, the second predetermined locations being different from and non-overlapping with the first predetermined locations;
wherein:
providing the first layer stack (41) comprises providing a passivating tunneling layer structure (13) on the n-type silicon substrate (10) and a first transparent conductive layer (14) on the passivating tunneling layer structure (13), the first transparent conductive layer (14) comprising a material with a high work function for inducing the emitter region (20); and
providing the second layer stack (42) comprises providing a passivating tunneling layer structure (13) on the n-type silicon substrate (10) and a second transparent conductive layer (14) on the passivating tunneling layer structure (13), the second transparent conductive layer (14) comprising a material with a low work function for inducing the back surface field region (30).

7. The method according to claim 6, wherein the method is performed at temperatures not exceeding 600°C.

8. The method according to claim 6 or 7, wherein providing the passivating tunneling layer (13) comprises providing a thin dielectric layer.

9. The method according to claim any of claims 6 to 8, wherein providing the passivating tunneling layer (13) comprises providing a monolayer of a passivating atomic species.

10. The method according to any of claims 6 to 9, wherein providing the first transparent conductive layer (14) comprises providing the first transparent conductive layer by solution processing and wherein providing the second transparent conductive layer (15) comprises providing the second transparent conductive layer by solution processing.

11. The method according to any of claims 6 to 10, further comprising providing a first metal layer (16) on the first transparent conductive layer (14) and providing a second metal layer (17) on the second transparent conductive layer (15).

## Patentansprüche

1. Photovoltaikzelle mit Rückkontakt (100), umfassend:
ein n-leitendes Siliziumsubstrat (10);
eine Emitter-Region (20), die an ersten vorbestimmten Stellen auf einer Rückseite (102) des n-leitenden Siliziumsubstrats (10) angeordnet ist;
eine Rückflächenfeldregion (30), die an zweiten vorbestimmten Stellen auf der Rückseite (102) des n-leitenden Siliziumsubstrats (10) angeordnet ist, wobei die zweiten vorbestimmten Stellen anders als und nicht überlappend mit den ersten vorbestimmten Stellen sind,
wobei die Emitter-Region (20) und die Rückflächenfeldregion (30) feldinduzierte Regionen sind;
einen ersten Schichtstapel (41), der konfiguriert ist, um eine Inversionsregion in dem n-leitenden Siliziumsubstrat an den ersten vorbestimmten Stellen zu induzieren, wobei die Inversionsregion die Emitter-Region (20) bildet; und
einen zweiten Schichtstapel (42), der konfiguriert ist, um eine Speicherregion in dem n-leitenden Siliziumsubstrat an den zweiten vorbestimmten Stellen zu induzieren, wobei die Speicherregion die Rückflächenfeldregion (30) bildet;
wobei:
jeder von dem ersten Schichtstapel (41) und dem zweiten Schichtstapel (42) eine passivierende Tunnelschichtstruktur (13) umfasst, die auf dem n-leitenden Siliziumsubstrat (10) angeordnet ist; der erste Schichtstapel (41) ferner eine erste transparente leitfähige Schicht (14) umfasst, die auf der passivierenden Tunnelschichtstruktur (13) angeordnet ist und ein Material mit einer hohen Austrittsarbeit zum Induzieren der Emitter-Region (20) umfasst; und
der zweite Schichtstapel (42) ferner eine zweite transparente leitfähige Schicht (15) umfasst, die auf der passivierenden Tunnelschichtstruktur (13) angeordnet ist und ein Material mit einer geringen Austrittsarbeit zum Induzieren der Rückflächenfeldregion (30) umfasst.

2. Photovoltaikzelle mit Rückkontakt (100) nach Anspruch 1, wobei die erste transparente leitfähige Schicht (14) ein Material mit einer Austrittsarbeit in dem Bereich zwischen 5 eV und 6 eV umfasst.

3. Photovoltaikzelle mit Rückkontakt (100) nach Anspruch 1 oder 2, wobei die zweite transparente leitfähige Schicht (15) ein Material mit einer Austrittsarbeit in dem Bereich zwischen 3,5 eV und 4,5 eV umfasst.

4. Photovoltaikzelle mit Rückkontakt (100) nach einem der vorhergehenden Ansprüche, wobei die passivierende Tunnelschicht (13) eine dünne dielektrische Schicht oder eine Monoschicht einer passivierenden Atomart ist.

5. Photovoltaikzelle mit Rückkontakt (100) nach einem der vorhergehenden Ansprüche, wobei der erste Schichtstapel (41) ferner eine erste Metallschicht (16) auf der ersten transparenten leitfähigen Schicht (14) umfasst, und wobei der zweite Schichtstapel (42) ferner eine zweite Metallschicht (17) auf der zweiten transparenten leitfähigen Schicht (15) umfasst.

6. Verfahren zum Herstellen einer Photovoltaikzelle mit Rückkontakt (100), wobei das Verfahren folgende Schritte umfasst:
Bereitstellen an ersten vorbestimmten Stellen auf einer Rückfläche eines n-leitenden Siliziumsubstrats (10) eines ersten Schichtstapels (41), wobei der erste Schichtstapel (41) konfiguriert ist, um eine Emitter-Region (20) in dem n-leitenden Siliziumsubstrat (10) an den ersten vorbestimmten Stellen zu induzieren; und
Bereitstellen an zweiten vorbestimmten Stellen auf der Rückfläche des n-leitenden Siliziumsubstrats (20) eines zweiten Schichtstapels (42),
wobei der zweite Schichtstapel (42) konfiguriert ist, um eine Rückflächenfeldregion (30) in dem n-leitenden Siliziumsubstrat (10) an den zweiten vorbestimmten Stellen zu induzieren, wobei die zweiten vorbestimmten Stellen anders als und nicht überlappend mit den ersten vorbestimmten Stellen sind;
wobei:
das Bereitstellen des ersten Schichtstapels (41) das Bereitstellen einer passivierenden Tunnelschichtstruktur (13) auf dem n-leitenden Siliziumsubstrat (10) und einer ersten transparenten leitfähigen Schicht (14) auf der passivierenden Tunnelschichtstruktur (13) umfasst, wobei die erste transparente leitfähige Schicht (14) ein Material mit einer hohen Austrittsarbeit zum Induzieren der Emitter-Region (20) umfasst; und
das Bereitstellen des zweiten Schichtstapels (42) das Bereitstellen einer passivierenden Tunnelschichtstruktur (13) auf dem n-leitenden Siliziumsubstrat (10) und einer zweiten transparenten leitfähigen Schicht (14) auf der passivierenden Tunnelschichtstruktur (13) umfasst, wobei die zweite transparente leitfähige Schicht (14) ein Material mit einer niedrigen Austrittsarbeit zum Induzieren der Rückflächenfeldregion (30) umfasst.

7. Verfahren nach Anspruch 6, wobei das Verfahren bei Temperaturen von nicht mehr als 600 °C ausgeführt wird.

8. Verfahren nach Anspruch 6 oder 7, wobei das Bereitstellen der passivierenden Tunnelschicht (13) das Bereitstellen einer dünnen dielektrischen Schicht umfasst.

9. Verfahren nach Anspruch nach einem der Ansprüche 6 bis 8, wobei das Bereitstellen der passivierenden Tunnelschicht (13) das Bereitstellen einer Monoschicht einer passivierenden Atomart umfasst.

10. Verfahren nach einem der Ansprüche 6 bis 9, wobei das Bereitstellen der ersten transparenten leitfähigen Schicht (14) das Bereitstellen der ersten transparenten leitfähigen Schicht durch Lösungsverarbeitung umfasst, und wobei das Bereitstellen der zweiten transparenten leitfähigen Schicht (15) das Bereitstellen der zweiten transparenten leitfähigen Schicht durch Lösungsverarbeitung umfasst.

11. Verfahren nach einem der Ansprüche 6 bis 10, ferner umfassend das Bereitstellen einer ersten Metallschicht (16) auf der ersten transparenten leitfähigen Schicht (14) und das Bereitstellen einer zweiten Metallschicht (17) auf der zweiten transparenten leitfähigen Schicht (15).

## Revendications

1. Cellule photovoltaïque à contact arrière (100), comprenant :
un substrat en silicium de type n (10) ;
une zone d'émetteur (20) disposée à des premiers emplacements prédéterminés sur un côté arrière (102) du substrat en silicium de type n (10) ;
une zone de champ de surface arrière (30) disposée à des deuxièmes emplacements prédéterminés sur le côté arrière (102) du substrat en silicium de type n (10), les deuxièmes emplacements prédéterminés étant différents des premiers emplacements prédéterminés, et sans chevauchement avec ceux-ci, dans laquelle la zone d'émetteur (20) et la zone de champ de surface arrière (30) sont des zones induites par champ ;
un premier empilement de couches (41) configuré pour induire une zone d'inversion dans le substrat en silicium de type n aux premiers emplacements prédéterminés, la zone d'inversion formant la zone d'émetteur (20) ; et
un deuxième empilement de couches (42) configuré pour induire une zone d'accumulation dans le substrat en silicium de type n aux deuxièmes emplacements prédéterminés, la zone d'accumulation formant la zone de champ de surface arrière (30) ;
dans laquelle :
chacun des premier empilement de couches (41) et deuxième empilement de couches (42) comprend une structure de couche à effet tunnel de passivation (13) disposée sur le substrat en silicium de type n (10) ;
le premier empilement de couches (41) comprend en outre une première couche conductrice transparente (14) disposée sur la structure de couche à effet tunnel de passivation (13) et comprenant un matériau avec un travail d'extraction élevé pour induire la zone d'émetteur (20) ; et
le deuxième empilement de couches (42) comprend en outre une deuxième couche conductrice transparente (15) disposée sur la structure de couche à effet tunnel de passivation (13) et comprenant un matériau avec un travail d'extraction faible pour induire la zone de champ de surface arrière (30).

2. Cellule photovoltaïque à contact arrière (100) selon la revendication 1, dans laquelle la première couche conductrice transparente (14) comprend un matériau avec un travail d'extraction dans la plage comprise entre 5 eV et 6 eV.

3. Cellule photovoltaïque à contact arrière (100) selon la revendication 1 ou 2, dans laquelle la deuxième couche conductrice transparente (15) comprend un matériau avec un travail d'extraction dans la plage comprise entre 3,5 eV et 4,5 eV.

4. Cellule photovoltaïque à contact arrière (100) selon l'une quelconque des revendications précédentes, dans laquelle la couche à effet tunnel de passivation (13) est une couche mince diélectrique ou une monocouche d'une espèce atomique de passivation.

5. Cellule photovoltaïque à contact arrière (100) selon l'une quelconque des revendications précédentes, dans laquelle le premier empilement de couches (41) comprend en outre une première couche métallique (16) sur la première couche conductrice transparente (14), et dans laquelle le deuxième empilement de couches (42) comprend en outre une deuxième couche métallique (17) sur la deuxième couche conductrice transparente (15).

6. Procédé pour la fabrication d'une cellule photovoltaïque à contact arrière (100), le procédé comprenant :
la fourniture à des premiers emplacements prédéterminés sur une surface arrière d'un substrat en silicium de type n (10) d'un premier empilement de couches (41), dans lequel le premier empilement de couches (41) est configuré pour induire une zone d'émetteur (20) dans le substrat en silicium de type n (10) aux premiers emplacements prédéterminés ; et
la fourniture à des deuxièmes emplacements prédéterminés sur la surface arrière du substrat en silicium de type n (20) d'un deuxième empilement de couches (42), dans lequel le deuxième empilement de couches (42) est configuré pour induire une zone de champ de surface arrière (30) dans le substrat en silicium de type n (10) aux deuxièmes emplacements prédéterminés, les deuxièmes emplacements prédéterminés étant différents des premiers emplacements prédéterminés et sans chevauchement avec ceux-ci ;
dans lequel :
la fourniture du premier empilement de couches (41) comprend la fourniture d'une structure de couche à effet tunnel de passivation (13) sur le substrat en silicium de type n (10) et d'une première couche conductrice transparente (14) sur la structure de couche à effet tunnel de passivation (13), la première couche conductrice transparente (14) comprenant un matériau avec un travail d'extraction élevé pour induire la zone d'émetteur (20) ; et
la fourniture du deuxième empilement de couches (42) comprend la fourniture d'une structure de couche à effet tunnel de passivation (13) sur le substrat en silicium de type n (10) et d'une deuxième couche conductrice transparente (14) sur la structure de couche à effet tunnel de passivation (13), la deuxième couche conductrice transparente (14) comprenant un matériau avec un travail d'extraction faible pour induire la zone de champ de surface arrière (30).

7. Procédé selon la revendication 6, dans lequel le procédé est réalisé à des températures ne dépassant pas 600°C.

8. Procédé selon la revendication 6 ou 7, dans lequel la fourniture de la couche à effet tunnel de passivation (13) comprend la fourniture d'une couche mince diélectrique.

9. Procédé selon l'une quelconque des revendications 6 à 8, dans lequel la fourniture de la couche à effet tunnel de passivation (13) comprend la fourniture d'une monocouche d'une espèce atomique de passivation.

10. Procédé selon l'une quelconque des revendications 6 à 9, dans lequel la fourniture de la première couche conductrice transparente (14) comprend la fourniture de la première couche conductrice transparente grâce à un traitement en solution, et dans lequel la fourniture de la deuxième couche conductrice transparente (15) comprend la fourniture de la deuxième couche conductrice transparente grâce à un traitement en solution.

11. Procédé selon l'une quelconque des revendications 6 à 10, comprenant en outre la fourniture d'une première couche métallique (16) sur la première couche conductrice transparente (14) et la fourniture d'une deuxième couche métallique (17) sur la deuxième couche conductrice transparente (15).
